# EUROPEAN PATENT SPECIFICATION

(11) **EP 2 494 593 B1**
(45) Date of publication and mention of the grant of the patent: **06.11.2013**
(21) Application number: 10762645.9
(22) Date of filing: 30.09.2010
(51) Int. Cl.: H01L 21/762

(54) **METHOD FOR CONTROLLING THE DISTRIBUTION OF STRESSES IN A SEMICONDUCTOR-ON-INSULATOR TYPE STRUCTURE AND CORRESPONDING STRUCTURE.**
VERFAHREN ZUR STEUERUNG DER BELASTUNGSVERTEILUNG AUF EINER SOI-STRUKTUR UND ZUGEHÖRIGE STRUKTUR
PROCÉDÉ DE MAÎTRISE DE LA DISTRIBUTION DE CONTRAINTES DANS UNE STRUCTURE DE TYPE SEMI-CONDUCTEUR SUR ISOLANT ET STRUCTURE CORRESPONDANTE

(30) Priority: 30.10.2009 FR 0957662
(43) Date of publication of application: 05.09.2012
(73) Proprietor: Soitec, 38190 Bernin (FR)
(72) Inventor: KERDILES, Sébastien, F-38330 Saint-Ismier (FR); REYNAUD, Patrick, F-38420 Murianette (FR)
(74) Representative: Regimbeau
(86) International application number: PCT/EP2010/064604
(87) International publication number: WO 2011/051078

(56) References cited:
- EP-A2- 1 662 560
- WO-A1-2009/112306
- US-B1- 6 331 473

## Description

The invention relates to a method for controlling the distribution of stresses in a structure of the semiconductor-on-insulator type during its manufacturing.

It also relates to such a structure, which may be used in the fields of microelectronics, optoelectronics, integrated photonics, etc.

With bonding by molecular adhesion it is possible to make substrates of the SOI (Silicon On Insulator) type, by burying an insulating layer between a mechanical supporting substrate and an active semiconductor layer.

Generally, SOI substrates include an active layer and a mechanical supporting substrate in single-crystal silicon, while the insulator is often a silicon oxide.

Methods such as those respectively known under the brand of "Smart Cut" or under the acronym of "BESOI" ("Bonded and Etched-Back Silicon on Insulator") involve the adhesive bonding of two substrates, one being the receiver (future mechanical supporting substrate) and the other one being the donor, from which the active layer is extracted. In order to form the buried insulator, all or part of the insulator may be formed or deposited on either one of the two substrates to be bonded, see for example document EP 1662 560.

Currently, the totality of the insulator is formed on the donor substrate, in particular if the final buried insulator is thin (< 500nm). In other cases, in particular if the buried insulator is thick (> 2000nm), the donor substrate may only bring a small portion of the future buried insulator (e.g.: 200nm), the remainder (e.g.: 1800nm) being provided by the supporting substrate.

The presence of a buried insulator leads to deformation of the finished SOI. Indeed, for example, in the case of buried Si oxide (100-1000nm) between a support of thickness 400-800µm and an active layer of Si with a thickness of 10-10,000nm, the structure is not symmetrical and deforms because the oxide does not have the same heat expansion coefficient as silicon. It is again found under stress, a stress which relaxes in order to give a "deflection" i.e. a deformation to the finished SOI substrate. This deflection is all the greater since the insulator is thick.

A slight deformation of the thereby made wafers is tolerable by the users. On the other hand, beyond a certain deformation (amplitude < 50µm) depending on the fineness of the components made on the SOIs, focusing problems occur during photolithographic steps, or even to the utmost, problems in handling of the wafers by robots.

It is therefore required to provide SOI wafers with the desired buried insulator thickness, without however the deformation of these SOIs being significant. The manufacturing of an SOI with a thick buried insulator and with small deflection is therefore difficult and requires resorting to particular precautions and methods,

Up to now, in order to limit the stresses and therefore the deflection, a first solution consists of manufacturing SOIs with a thick buried insulator by adhesively bonding a donor substrate only providing a small portion of the oxide, and a receiver which includes the major portion of the future buried oxide, or even the totality thereof.

In order to avoid deformation of the finished SOI, the receiver should not only include the oxide on the front face, but also on the rear face (which for example is the case with thermal oxidation).

This rear face oxide should be preserved until the end of the SOI manufacturing method, which is a constraint since the different deoxidation steps (at least one deoxidation after the stabilisation step, possibly a second one after the thinning step) have only to be performed on the front face.

This kind of method is feasible but costly and imposes the manufacturing of thick buried oxide SOIs by means of specific equipment (deoxidation exclusively on the front face, etc.).

Moreover, SOIs with such an oxide on the rear face, delivered to the manufacturers of electronic components, also force the users to themselves perform deoxidations only on the front face.

The deformation of an oxide structure on the rear face will be zero if the thick buried oxide SOI includes the same oxide thickness on the rear face of the receiver substrate.

If during the method for manufacturing the SOI or components on this SOI, rear face oxide is partly removed, the deformation again appears with an amplitude depending on the difference in thickness between the buried oxide and that on the rear face.

For example, an SOI with buried oxide (BOX) of thickness 1,000nm is characterized by a deformation amplitude of about 85µm, if no oxide is present in the rear face. This amplitude can be reduced to about 40µm if 500nm of oxide are left in the rear face.

The present invention therefore aims to solve this problem by proposing a method for controlling the distribution of the stresses in a structure of the semiconductor-on-insulator type during its manufacturing, which is simple and easy to apply, and with which the deformation of the obtained structure may be "managed" on demand.

Thus, this method for controlling the distribution of the stresses of distribution in a structure of the semiconductor-on-insulator type during its manufacturing, which includes a thin layer of semiconducting material on a supporting substrate, an insulating layer being present on each of the front and rear faces of the supporting substrate, the front insulating face forming at least one portion of a thick buried insulator, a manufacturing method according to which it is proceeded with adhesive bonding of said thin layer on said supporting substrate, is characterized by the fact that prior to bonding, it is proceeded with covering of said insulating layer, on the rear face of said supporting substrate with a distinct material withstanding deoxidations, a material which, in combination with this insulating layer on the rear face of the supporting substrate, at least partly compensates for the stress exerted by the buried insulator on the supporting substrate.

In this way, not only the insulating layer on the rear face of the supporting substrate at least partly compensates for the stress exerted by the buried insulator on the supporting substrate, but is also protected by the material withstanding deoxidations.

In the whole of the present application, the terms and expressions hereafter will have the associated definitions:
- thick buried insulator: a buried insulator with a thickness of at least 500nm, or even of at least 800nm;
- material withstanding deoxidations: a material for which the etching rate by hydrofluoric acid (HF, at a concentration comprised between 0.5% and 50%, preferentially from 10 to 20%, and at a temperature generally comprised between 20 and 25°C) is at least 10 times less than that of silicon oxide.

According to other advantageous and nonlimiting features:
- said insulating layer notably includes oxide;
- said thick buried insulator consists of an insulator layer added onto the thin layer and/or of an insulator layer added on the supporting substrate;
- the thick buried insulator and the insulating layer on the rear face of the supporting substrate exert a same stress level on this substrate;
- the thick buried insulator and the insulating layer on the rear face of the supporting substrate exert different stress levels on this substrate;
- with said material withstanding deoxidations, it is proceeded not only with covering of the rear face of said supporting substrate, but also with covering its other faces, in order to encapsulate it entirely;
- the layer of said material withstanding deoxidations on the front face of said supporting substrate is removed;
- said material withstanding deoxidations is selected from polycrystalline silicon, notably doped with boron or phosphorus for example, amorphous silicon, possibly doped or silicon nitrides;
- said material withstanding deoxidations is polycrystalline silicon and, prior to covering the insulating layer on the rear face of said supporting substrate, it is proceeded with the removal of an intermediate insulating layer on the front face of said supporting substrate;
- said intermediate insulating layer is a layer obtained during the formation of the insulating layer on the rear face of said supporting substrate;
- said insulating layer on the front face of said supporting substrate is formed by thermal oxidation, or by depositing oxide on the polycrystalline silicon and/or on a donor substrate which integrates said thin layer;
- said supporting substrate is subject to a treatment capable of imparting high resistivity to it, i.e. at least greater than 500Ω.cm, preferentially greater than 1,000Ω.cm.

Moreover, the invention relates to a structure of the semiconductor-on-insulator type, which includes a thin layer of semiconducting material on a supporting substrate, an insulating layer being present on each of the front and rear faces of the supporting substrate, the layer on the front face forming at least one portion of a thick buried insulator,
characterized by the fact that it includes a layer for covering the insulating layer on the rear face of said supporting substrate consisting of a distinct material, withstanding deoxidations, a material which, in combination with this insulating layer on the rear face of the supporting substrate, at least partly compensates for the stress exerted by the buried insulator on the supporting substrate.

Advantageously, the difference in thickness between the insulator layers on the front face and on the rear face of the supporting substrate is less than or equal to 200 nanometers.

Other features and advantages of the present invention will become apparent upon reading the description which follows of certain embodiments. This description will be made with reference to the appended drawings wherein:
- Figs. 1-3 are sectional views of a structure according to the invention illustrated in three different stress conditions, respectively;
- Fig. 4 is a sectional view of a further alternative of the structure;
- Figs. 5A-5J are simplified views of the steps with which the structure of Fig. 1 may be obtained.

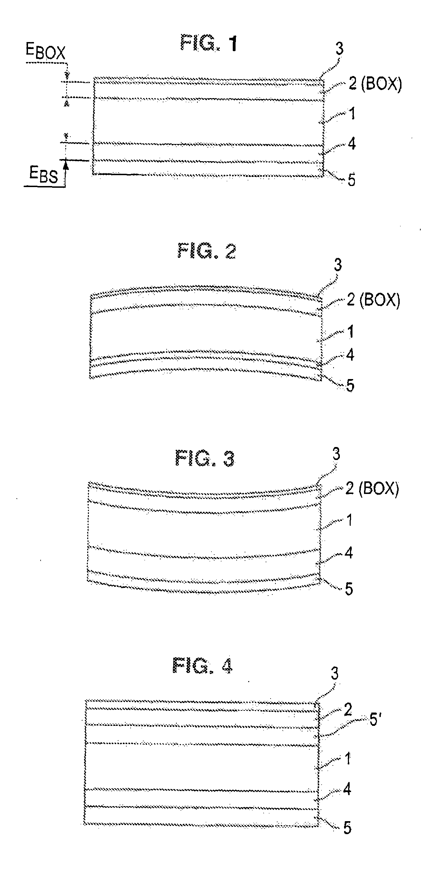

A structure according to the invention is visible in Fig. 1. On a mechanical supporting substrate 1, the SOI comprises a buried insulator 2 of thickness EBOX and an active layer 3.

Under the supporting substrate, an encapsulated insulator 4 of thickness EBS is located between this support and a layer 5 which protects the insulator 4 from etchings or deoxidations.

The deformation of the thereby formed SOI is managed by selecting the thickness and the stress of the layers of insulators 2 and 4. In the case when the stress is identical, the deformation is closer to zero if EBS = EBOX (Fig. 1).

In order to anticipate deformations occurring subsequently in the method for manufacturing components on the SOI, the operator may require an SOI with non-zero deformation, i.e, positive deflection (EBS < EBOX, when the SOI is convex, as shown in Fig. 2) or negative deflection (EBS > EBOX, when the SOI is concave as shown in Fig. 3).

In the case when the insulator layers 2 and 4 do not have the same stress level, one may be led to taking this stress into account in order to adjust the thickness of the layer 4 in order to attain the desired deformation. Also, if the layer 5 encapsulated in the insulator on the rear face contributes to the deformation of the SOI, the thickness of the layers 4 and 5 may also be corrected.

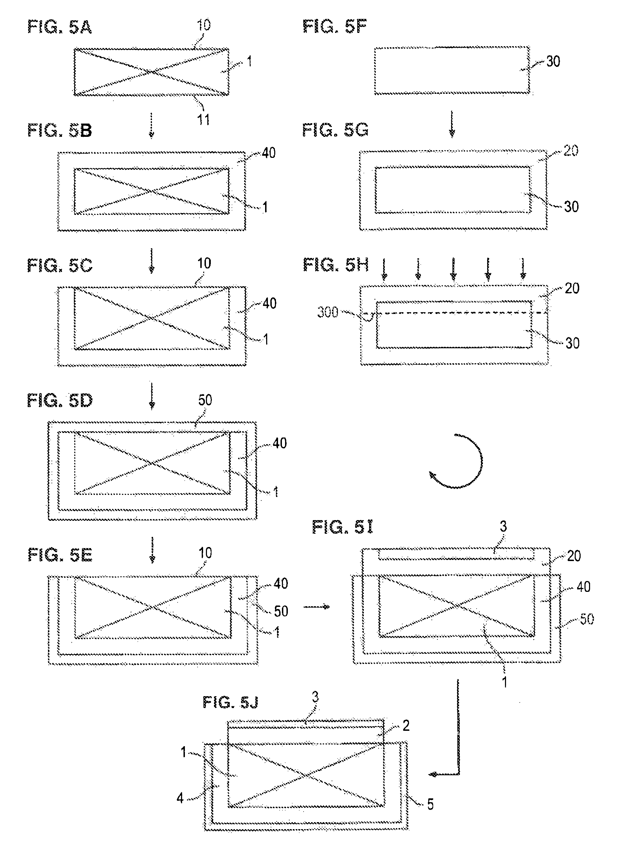

The different steps of the method with which the structure illustrated in Fig. 1 may be obtained, are illustrated in Figs. 5A-5J.

Here, this is a structure, for which both the supporting and donor substrates are in silicon with a silicon oxide insulator.

The supporting substrate in silicon 1 is illustrated in Fig. 5A and its front and rear faces are identified by the references 10 and 11.

A step for forming an insulator 40 is illustrated in Fig. 5B, which is typically formed by thermal oxidation of the supporting substrate, or further by depositing a thin layer, notably by the Low chemical Pressure Vapor Deposition (LPCVD) technique.

The oxide formed in this step on the rear face of the supporting substrate 1 has a thickness equal to the future buried oxide which will be formed under the future active layer.

As illustrated in Fig. 5C, it is proceeded with deoxidation only on the front face 10 of the supporting substrate 1.

As shown in Fig. 5D, a deposition of an encapsulation layer 50 is then carried out on all the surfaces of the supporting substrate, for example with said LPCVD technique, and it is then proceeded with removing this layer on the front face of the supporting substrate, as shown in Fig. 5E.

The material used for the encapsulation layer 50 may for example be a layer of polycrystalline silicon, amorphous silicon, or further a layer of silicon nitride.

A donor substrate 30 is illustrated in Fig. 5F.

As shown in Fig. 5G, it is proceeded with thermal oxidation so as to form an oxide 20 with a thickness identical to the buried oxide under the supporting substrate 1, so as to obtain a finished structure with quasi-zero deformation.

A step for ion implantation in the donor substrate in order to form an embrittlement area 300 is illustrated in Fig. 5H.

It is then proceeded with turning-over of the donor substrate 30 and with bonding by molecular adhesion onto the supporting substrate 1.

It is then proceeded with fracture of the donor substrate 30 along the embrittlement area 300 in order to transfer it onto the supporting substrate 1, the semiconducting material layer 3 and its insulator 20.

Finally, it is proceeded with steps for finishing the structure by notably applying deoxidations by immersion in one or several pans of hydrofluoric acid (HF), in order to obtain the structure illustrated in Fig. 5J.

During these steps for finishing the SOI (steps after transferring the thin layer), one or more cleaning operations comprising an HF bath are used for removing the oxide on the front face of the supporting substrate.

During these immersions, its rear face is also exposed to etching by HF.

However, because of the presence of the encapsulation layer, the latter is not or practically not etched.

Thus, the etching rate by HF of a nitride layer obtained by LPCVD is about 30 times slower than that of a thermal oxide. The etching rate of an amorphous or polycrystalline silicon layer is quasi-zero under the same conditions. From a selectivity at least equal to 10, it may be considered, as mentioned above, that the material withstands deoxidations.

An alternative of the structure according to the invention is illustrated in Fig. 4, which has high resistivity. It includes a polycrystalline silicon layer 5' under the buried oxide 2, and has zero deformation, in spite of a buried oxide with a thickness of 1,000nm, this by an oxide layer 4 on the rear face of the supporting substrate 1, which is encapsulated under a layer of polycrystalline silicon 5.

The manufacturing technique for this structure is substantially the same as the one indicated above.

However, the supporting substrate was subject beforehand to heat treatment making it highly resistive (resistivity greater than 500Ω.cm, preferentially greater than 1,000Ω.cm).

Moreover, it undergoes thermal oxidation in order to generate an oxide with a thickness of 800nm on all its faces.

After deoxidation of its front face, it is proceeded with the LPCVD deposition of polycrystalline silicon on all its faces, over a thickness of one micrometer.

Thermal oxidation of a donor substrate is thereby achieved so as to form an oxide layer of 800nm, i.e. with a thickness identical with that of the oxide already formed under the supporting substrate, in order to obtain a finished structure with quasi-zero deformation.

The thereby obtained structure benefits from a buried oxide 4 on the rear face which ensures minimum deformation, it compensates for the stresses which would have been caused by the buried oxide 2 under the active layer 3.

The polycrystalline silicon 5 and 5' which is deposited is practically pure (residual doping level of less than 1 x 10¹⁵ atoms per cm²), so as to provide under the buried oxide 2 a layer 5' which further improves the electric performances of the structure in the radiofrequency range.

Further, with the polycrystalline silicon layer 5 on the rear face of the supporting substrate, it is possible to protect the oxide layer 4 from etchings during the finishing of the structure and to continue to protect it until the end of the method for manufacturing components of the structure.

In another exemplary embodiment not shown in the figures, it is proceeded with thermal oxidation of a supporting substrate over a thickness of 1,800nm.

It is then proceeded with deposition of amorphous silicon (1µm), on all the faces of the supporting substrate, and then with removal of this amorphous silicon on its front face.

Thermal oxidation of a donor substrate on a thickness of 200nm is applied.

Finally, it is proceeded with the making of an SOI by the aforementioned Smart-Cut technique, by means of both of these substrates.

It is characterized by a buried oxide with a total thickness of 2µm and an oxide on the rear face of 1.8µm encapsulated by amorphous silicon. The thereby obtained SOI typically has a deflection of 20µm (slightly convex). This deformation would be of the order of 200µm if the oxide was not encapsulated on the rear face of the supporting substrate.

## Claims

1. A method for controlling the distribution of the stresses in a structure of the semiconductor-on-insulator type during its manufacturing, which includes a thin layer of semiconducting material (3) on a supporting substrate (1), an insulating layer (2, 4) being present on each of the front (10) and rear (11) faces of the supporting substrate (1), the insulating layer on the front face (2) forming at least one portion of thick buried insulator (BOX), a manufacturing method according to which it is proceeded with adhesive bonding of said thin layer (3) on said supporting substrate (1),
**characterized by** the fact that, prior to the adhesive bonding, it is proceeded with covering of the insulating layer (4) on the rear face of said supporting substrate with a distinct material (5) withstanding deoxidations, said distinct material (5) being a material for which the etching rate by hydrofluoric acid HF, at a concentration comprised between 0.5% and 50%, preferentially from 10 to 20%, and at a temperature generally comprised between 20 and 25°C is at least 10 times less than that of silicon oxide, said distinct material (5) withstanding deoxidations which in combination with this insulating layer (4) on the rear face (11) of the supporting substrate, at least partly compensates for the stress exerted by the buried insulator (BOX) on the supporting substrate (1).

2. The method according to claim 1, **characterized by** the fact that said insulating layer (2, 4) notably includes oxide.

3. The method according to claim 1 or 2, **characterized by** the fact that said thick buried insulator (BOX) consists of an insulator layer (2) added onto the thin layer (3) and/or of an insulator layer added onto the supporting layer (1).

4. The method according to any of the preceding claims, **characterized by** the fact that the thick buried insulator (BOX) and the insulating layer (4) on the rear face (11) of the supporting substrate (1) exert a same stress level on this substrate (1).

5. The method according to any of claims 1 to 3, **characterized by** the fact that the thick buried insulator (BOX) and the insulating layer (4) on the rear face (11) of the supporting substrate (1) exert different stress levels on this substrate (1).

6. The method according to any of the preceding claims, **characterized by** the fact that with said material (5) withstanding deoxidations, it is proceeded not only with covering the rear face (11) of said supporting substrate (1), but also with covering its other faces, so as to encapsulate it entirely.

7. The method according to claim 6, **characterized by** the fact that the layer of said material (5) withstanding deoxidations on the front face (10) of said supporting substrate (1) is removed.

8. The method according to any of the preceding claims, **characterized by** the fact that said material (5) withstanding deoxidations is selected from polycrystalline silicon, notably doped with boron or phosphorus for example, amorphous silicon, possibly doped or silicon nitrides.

9. The method according to claim 8, wherein said material withstanding deoxidations (5) is polycrystalline silicon, **characterized by** the fact that prior to covering the insulating layer (4), on the rear face (11) of said supporting substrate (1), it is proceeded with the removal of an intermediate insulating layer on the front face (10) of said supporting substrate (1).

10. The method according to claim 9, **characterized by** the fact that said intermediate insulating layer is a layer obtained during the formation of the insulating layer (4) on the rear face of said supporting substrate (1)

11. The method according to any of claims 9 or 10, **characterized by** the fact that said insulating layer (2) on the front face of said supporting substrate (1) is formed by thermal oxidation, or by deposition of oxide on the polycrystalline silicon and/or on a donor substrate (30) which integrates said thin layer (3).

12. The method according to any of the preceding claims, **characterized by** the fact that said supporting substrate (1) is subject to a treatment capable of imparting high resistivity to it, i.e. at least greater than 500Ω.cm, preferentially greater than 1,000Ω.cm.

13. A structure of the semiconductor-on-insulator type, which includes a thin layer (3) of semiconducting material on a supporting substrate (1), an insulating layer (2; 4) being present on each of the front (10) and rear (11) faces of the supporting substrate (1), the layer on the front face (11) forming at least one portion of a thick buried insulator (BOX),
**characterized by** the fact that it includes a layer (5) for covering the insulating layer (4) on the rear face (11) of said supporting substrate (1) consisting of a distinct material withstanding deoxidations, said distinct material (5) being a material for which the etching rate by hydrofluoric acid HF, at a concentration comprised between 0.5% and 50%, preferentially from 10 to 20%, and at a temperature generally comprised between 20 and 25°C is at least 10 times less than that of silicon oxide, said distinct material (5) withstanding deoxidations which in combination with this insulating layer (4) on the rear face of the supporting substrate (1) at least partly compensates for the stress exerted by the buried insulator (BOX) on the supporting substrate (1).

14. The structure according to the preceding claim, **characterized by** the fact that the thickness difference between the layers of insulator (2) on the front face (10) and on the rear face (11) of the supporting substrate (1) is less than or equal to 200 nanometers.

## Patentansprüche

1. Verfahren zur Steuerung der Belastungsverteilung in einer Halbleiter-auf-Isolator-Struktur während seiner Herstellung, welche eine dünne Schicht eines Halbleitermaterials (3) auf einem tragendem Substrat (1) und eine Isolationsschicht (2, 4), die sowohl auf der Vorderseite (10) als auch auf der Rückseite (11) des tragenden Substrats (1) vorhanden ist, aufweist, wobei die Isolationsschicht auf der Vorderseite (2) wenigstens einen Teil eines dicken vergrabenen Isolators (BOX) ausbildet, ein Herstellungsverfahren, bei welchem mit Adhäsionsbonden der dünnen Schicht (3) auf dem tragenden Substrat (1) fortgefahren wird,
**dadurch gekennzeichnet, dass** vor dem Adhäsionsbonden fortgefahren wird mit dem Beschichten der Isolationssicht (4) auf der Rückseite des tragenden Substrates mit einem bestimmten Material (5), welches Deoxidation widersteht, wobei das bestimmte Material (5) ein Material ist, für welches die Ätzgeschwindigkeit durch Fluorwasserstoffsäure HF, bei einer Konzentration zwischen 0.5% und 50%, vorzugsweise zwischen 10% bis 20%, und bei einer Temperatur, die im Allgemeinen zwischen 20° und 25° liegt, wenigstens 10 Mal geringer ist als die von Siliziumoxid, wobei das bestimmte Material (5) Deoxidation widersteht, und welches in Kombination mit dieser Isolationsschicht (4) auf der Rückseite (11) des tragenden Substrates wenigstens teilweise die Belastung kompensiert, die durch den vergrabenen Halbleiter (BOX) auf dem tragenden Substrat (1) ausgeübt wird.

2. Verfahren nach Anspruch 1, **dadurch gekennzeichnet, dass** die Isolationssicht (2, 4) in erheblichem Maße Oxid aufweist.

3. Verfahren nach Anspruch 1 oder 2, **dadurch gekennzeichnet, dass** der dicke vergrabene Isolator (BOX) aus einer Isolationsschicht (2), die auf die dünne Schicht (3) hinzugefügt wurde, und/oder aus einer Isolationssicht, die auf die tragende Schicht (1) hinzugefügt wurde, besteht.

4. Verfahren nach irgendeinem der vorherigen Ansprüche, **dadurch gekennzeichnet, dass** der dicke vergrabene Isolator (BOX) und die Isolationsschicht (4) auf der Rückseite (11) des tragenden Substrats (1) ein gleiches Belastungsniveau auf dieses Substrat (1) ausüben.

5. Verfahren nach irgendeinem der Ansprüche 1 bis 3, **dadurch gekennzeichnet, dass** der dicke vergrabene Isolator (BOX) und die Isolationsschicht (4) auf der Rückseite (11) des tragenden Substrats (1) verschiedene Belastungsniveaus auf dieses Substrat (1) ausüben.

6. Verfahren nach irgendeinem der vorherigen Ansprüche, **dadurch gekennzeichnet, dass** mit dem Material (5), das Deoxidation widersteht, nicht nur fortgefahren wird mit dem Beschichten der Rückseite (11) des tragenden Substrats (1), sondern auch mit dem Beschichten seiner anderen Seite, um es gänzlich zu verkapseln.

7. Verfahren nach Anspruch 6, **dadurch gekennzeichnet, dass** die Schicht des Materials (5), das Deoxidation widersteht, auf der Vorderseite (10) des tragenden Substrats (1) entfernt wird.

8. Verfahren nach irgendeinem der vorherigen Ansprüche, **dadurch gekennzeichnet, dass** das Material (5), das Deoxidation widersteht, ausgewählt wird aus polykristallinem Silizium, in erheblichem Maße dotiert mit beispielsweise Bor oder Phosphor, amorphem Silizium, möglicherweise dotiert, oder Siliziumnitriden.

9. Verfahren nach Anspruch 8, wobei das Material (5), das Deoxidation widersteht, polykristallines Silizium ist, **dadurch gekennzeichnet, dass** vor dem Beschichten der Isolationsschicht (4) auf der Rückseite (11) des tragenden Substrats (1) fortgefahren wird mit dem Entfernen einer Zwischen-Isolationsschicht auf der Vorderseite (10) des tragenden Substrats (1).

10. Verfahren nach Anspruch 9, **dadurch gekennzeichnet, dass** die Zwischen-Isolationsschicht eine Schicht ist, die während der Ausbildung der Isolationsschicht (4) auf der Rückseite des tragenden Substrats (1) erhalten wurde.

11. Verfahren nach irgendeinem der Ansprüche 9 oder 10, **dadurch gekennzeichnet, dass** die Isolationsschicht (2) auf der Vorderseite des tragenden Substrats (1) ausgebildet wird durch thermische Oxidation, oder durch Abscheiden von Oxid auf das polykristalline Silizium und/oder ein Donorsubstrat (30), welches die dünne Schicht (3) integriert.

12. Verfahren nach irgendeinem der vorherigen Ansprüche, **dadurch gekennzeichnet, dass** das tragende Substrat (1) einer Behandlung unterzogen wird, die dazu fähig ist ihm einen hohen Widerstand zu verleihen, i.e. wenigstens mehr als 500Ω.cm, vorzugsweise mehr als 1000Ω.cm.

13. Halbleiter-auf-Isolator-Struktur, welche eine dünne Schicht (3) eines Halbleitermaterials auf einem tragenden Substrat (1) und eine Isolationsschicht (2, 4), die sowohl auf der Vorderseite (10) als auch auf der Rückseite (11) des tragenden Substrates (1) vorhanden ist, aufweist, wobei die Schicht auf der Vorderseite (11) wenigstens einen Teil eines dicken vergrabenen Isolators (BOX) ausbildet,
**dadurch gekennzeichnet, dass** sie eine Schicht (5) zum Beschichten der Isolationsschicht (4) auf der Rückseite (11) des tragenden Substrats (1) aufweist, die aus einem bestimmten Material besteht, welches Deoxidation widersteht, wobei das bestimmte Material (5) ein Material ist, für welches die Ätzgeschwindigkeit durch Fluorwasserstoffsäure HF, bei einer Konzentration zwischen 0.5% und 50%, vorzugsweise zwischen 10% bis 20%, und bei einer Temperatur, die im Allgemeinen zwischen 20° und 25° liegt, wenigstens 10 Mal geringer ist als die von Siliziumoxid, wobei das bestimmte Material (5) Deoxidation widersteht, welches in Kombination mit dieser Isolationsschicht (4) auf der Rückseite des tragenden Substrates (1) wenigstens teilweise die Belastung kompensiert, die durch den vergrabenen Halbleiter (BOX) auf dem tragenden Substrat (1) ausgeübt wird.

14. Struktur nach dem vorherigem Anspruch, **dadurch gekennzeichnet, dass** der Unterschied in der Dicke zwischen den Isolatorschichten (2) auf der Vorderseite (10) und auf der Rückseite (11) des tragenden Substrats (1) geringer als oder gleich 200 Nanometer ist.

## Revendications

1. Procédé de contrôle, lors de sa fabrication, de la répartition des contraintes dans une structure de type semi-conducteur sur isolant, qui comporte une couche mince de matériau semi-conducteur (3) sur un substrat support (1), une couche isolante (2, 4) étant présente sur chacune des faces avant (10) et arrière (11) du substrat support (1), la couche isolante en face (2) avant constituant au moins une partie d'un isolant enterré épais (BOX), procédé de fabrication selon lequel on procède au collage, sur ledit substrat support (1), de ladite couche mince (3),
**caractérisé par le fait que**, préalablement au collage, on procède au recouvrement de la couche isolante (4), en face arrière dudit substrat support avec un matériau distinct (5) résistant aux désoxydations ledit matériau distinct étant un matériau dont la vitesse de gravure par de l'acide fluorhydrique HF, à une concentration comprise entre 0.5 % et 50 %, préférentiellement 10 à 20 %, et à température généralement comprise entre 20 et 25°C, est au moins 10 fois plus faible que celle de l'oxyde de silicium, matériau résistant aux oxydations qui compense, en combinaison avec cette couche isolante (4) en face arrière (11) du substrat support, au moins en partie la contrainte exercée par l'isolant enterré (BOX) sur le substrat support (1).

2. Procédé selon la revendication 1, **caractérisé par le fait que** ladite couche isolante (2,4) comporte notamment de l'oxyde.

3. Procédé selon la revendication 1 ou 2, **caractérisé par le fait que** ledit isolant enterré épais (BOX) est constitué d'une couche d'isolant (2) rapporté sur la couche mince (3) et/ou d'une couche d'isolant rapporté sur le substrat support (1).

4. Procédé selon l'une des revendications précédentes, **caractérisé par le fait que** l'isolant enterré épais (BOX) et la couche isolante (4) en face arrière (11) du substrat support (1) exercent un même niveau de contrainte sur ce substrat (1).

5. Procédé selon l'une des revendications 1 à 3, **caractérisé par le fait que** l'isolant enterré épais (BOX) et la couche isolante (4) en face arrière (11) du substrat support (1) exercent des niveaux de contrainte différents sur ce substrat (1).

6. Procédé selon l'une des revendications précédentes, **caractérisé par le fait que** l'on procède, avec ledit matériau résistant (5) aux désoxydations, non seulement au recouvrement de la face arrière (11) dudit substrat support (1), mais aussi au recouvrement de ses autres faces, de manière à l'encapsuler totalement.

7. Procédé selon la revendication 6, **caractérisé par le fait que** l'on retire la couche dudit matériau (5) résistant aux désoxydations en face avant (10) dudit substrat support (1).

8. Procédé selon l'une des revendications précédentes, **caractérisé par le fait que** ledit matériau (5) résistant aux désoxydations est choisi parmi le silicium polycristallin, notamment dopé, par exemple au bore ou au phosphore, le silicium amorphe, éventuellement dopé ou les nitrures de silicium.

9. Procédé selon la revendication 8, dans lequel ledit matériau résistant aux désoxydations (5) est du silicium polycristallin, **caractérisé par le fait que**, préalablement au recouvrement de la couche isolante (4), en face arrière (11) dudit substrat support (1), on procède à l'enlèvement d'une couche isolante intermédiaire en face avant (10) dudit substrat support (1).

10. Procédé selon la revendication 9, **caractérisé par le fait que** ladite couche isolante intermédiaire est une couche obtenue lors de la formation de la couche isolante (4) en face arrière dudit substrat support (1)

11. Procédé selon l'une des revendications 9 ou 10, **caractérisé par le fait que** ladite couche isolante (2) en face avant dudit substrat support (1) est formée par oxydation thermique, ou par dépôt d'oxyde sur le silicium polycristallin et/ou sur un substrat donneur (30) qui intègre ladite couche mince (3).

12. Procédé selon l'une des revendications précédentes, **caractérisé par le fait que** l'on soumet ledit substrat support (1) à un traitement apte à lui conférer une résistivité élevée, c'est à dire au moins supérieure à 500 Ω.cm, préférentiellement supérieure à 1000 Ω.cm.

13. Structure de type semi-conducteur sur isolant, qui comporte une couche mince (3) de matériau semi-conducteur sur un substrat support (1), une couche isolante (2 ; 4) étant présente sur chacune des faces avant (10) et arrière (11) du substrat support (1), la couche en face avant (11) constituant au moins une partie d'un isolant enterré épais (BOX),
**caractérisée par le fait qu'**elle comporte une couche (5) de recouvrement de la couche d'isolant (4) en face arrière (11) dudit substrat support (1) constituée d'un matériau distinct résistant aux désoxydations ledit matériau distinct étant un matériau dont la vitesse de gravure par de l'acide fluorhydrique HF, à une concentration comprise entre 0.5 % et 50 %, préférentiellement 10 à 20 %, et à température généralement comprise entre 20 et 25°C, est au moins 10 fois plus faible que celle de l'oxyde de silicium, matériau résistant aux oxydations qui compense, en combinaison avec cette couche isolante (4) en face arrière (11) du substrat support, au moins en partie la contrainte exercée par l'isolant enterré (BOX) sur le substrat support (1).

14. Structure selon la revendication précédente, **caractérisée par le fait que** la différence d'épaisseur entre les couches d'isolant (2) en face avant (10) et en face arrière (11) du substrat (1) support est inférieure ou égale à 200 nanomètres.
